# EUROPEAN PATENT APPLICATION

(11) **EP 4 557 364 A1**
(43) Date of publication of application: **21.05.2025**
(21) Application number: 24212721.5
(22) Date of filing: 13.11.2024
(51) Int. Cl.: H01L 23/495, H01L 23/544, H01L 23/00

(54) **METHOD OF MANUFACTURING SEMICONDUCTOR DEVICES, CORRESPONDING SUBSTRATE AND SEMICONDUCTOR DEVICE**

(30) Priority: 15.11.2023 IT 202300024210
(71) Applicant: STMicroelectronics International N.V., 1228 Plan-les-Ouates, Geneva (CH)
(72) Inventor: CATALANO, Guendalina, I-20125 Milano (IT); DI MAURO, Oscar, I-98030 Gaggi (Messina) (IT)
(74) Representative: Buzzi, Notaro & Antonielli d'Oulx S.p.A.

(57) **Abstract**

A semiconductor die (14) is arranged at a mounting surface of a substrate (12) via electrically conductive pillars (120) protruding from the semiconductor die (14) with distal ends of the electrically conductive pillars (120) in electrical contact (SM) with the mounting surface of the substrate (12).

The substrate (12) has at the mounting surface two or more alignment bushings (100) configured to have inserted therein respective electrically conductive pillars (120).

Selected ones of the electrically conductive pillars (120) protruding from the semiconductor die (14) are inserted into the two or more alignment bushings (100) at the mounting surface of the substrate (12).

The pillars (120) inserted into the alignment bushings (100) counter movement of the semiconductor die (14) with respect to the substrate (12).

## Description

### Technical field

The description relates to manufacturing semiconductor devices.

One or more embodiments may be applied to manufacturing integrated circuit (IC) semiconductor devices such as DC-DC converters or microcontrollers, for instance.

### Background

In current manufacturing processes of (integrated circuit) semiconductor devices (microcontrollers or DC-DC converters, for instance) a semiconductor die or chip may be mounted on a substrate via the so-called flip-chip mounting.

In semiconductor devices processed via flip-chip mounting a plurality of electrically conductive pillars (or bumps) is provided on a surface of the semiconductor die.

Solder material is provided at the terminal portion of the electrically conductive pillars configured to contact the substrate in order to form, after reflow, the desired electrical coupling between the semiconductor die and the substrate.

During reflow, the semiconductor die may undesirably move with respect to the substrate resulting in an inadequate electrical coupling between the semiconductor die and the substrate.

Document US 20210265247 A1 is exemplary of recent advances in manufacturing methods of semiconductor devices aiming at providing self-alignment features for flip chip devices.

Document US 20130292037 A1 discloses an apparatus comprising a first substrate and a second substrate. The first substrate has disposed thereon a first feature. The second substrate has disposed thereon a second feature. The first feature is configured to interlock with the second feature such that the first substrate and the second substrate are aligned by the first and the second features within a predefined accuracy.

Document US 20140210076 A1 discloses a method of forming a hybridized device including forming a first component provided with metal bumps, and a second component provided with connection elements, attaching the bumps to the connection elements. The manufacturing of the second component includes forming, on a surface of a substrate, resistive elements at the locations provided for the connection elements; depositing an electric insulator layer at least on the resistive elements; and forming the connection elements, each comprising a metal well having an opening capable of receiving the corresponding metal bump of the first microelectronic component and at least partially filled with a fusible element, particularly indium or an alloy of tin and gold, or with a conductive ink, particularly based on silver or copper. Further, the attachment of the balls to the connection elements comprises applying an electric current through the resistive elements to heat the bumps.

Documents US 20120326322 A1, US 20180019191 A1 and US 20170309595 A1 provide background information in the related technological area.

### Object and summary

An object of one or more embodiments is to overcome the drawbacks discussed in the foregoing.

According to one or more embodiments, that object can be achieved via a method having the features set forth in the claims that follow.

One or more embodiments relate to a corresponding intermediate product. A substrate for use in manufacturing semiconductor devices and suited to be provided by a supplier to a manufacturer of semiconductor devices can be exemplary of such an intermediate product.

One or more embodiments relate to a corresponding semiconductor device comprising such a substrate.

The claims are an integral part of the technical teaching provided in respect of the embodiments.

Solutions as described herein involve providing alignment formations on a substrate in order to facilitate aligning and mounting a semiconductor die on the substrate.

In solutions as described herein, the alignment formations may be provided on the substrate via additive manufacturing techniques such as laser induced forward transfer, LIFT, for instance.

In solutions as described herein, the alignment formations provided on the substrate also facilitate reducing undesired displacement/movement of the semiconductor die mounted on the substrate during handling and/or processing.

Solutions as described herein may advantageously be applied to flip-chip package devices for DC-DC converters or microcontrollers, for instance.

### Brief description of the figures

One or more embodiments will now be described, by way of example only, with reference to the annexed figures, wherein:
Figure 1 is a cross-sectional view illustrative of the structure of a semiconductor device,
Figure 2 is a plan view illustrative of substrates for semiconductor devices according to embodiments of the present description,
Figure 3 is a perspective view of the structure of a semiconductor device according to embodiments of the present description,
Figure 4 is an enlarged view of the portion of Figure 3 indicated by the arrow IV, and
Figures 5A to 5C are cross-sectional views illustrative of a sequence of step in the manufacturing process of a semiconductor device according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments. The references used herein are provided merely for convenience and hence do not define the extent of protection or the scope of the embodiments.

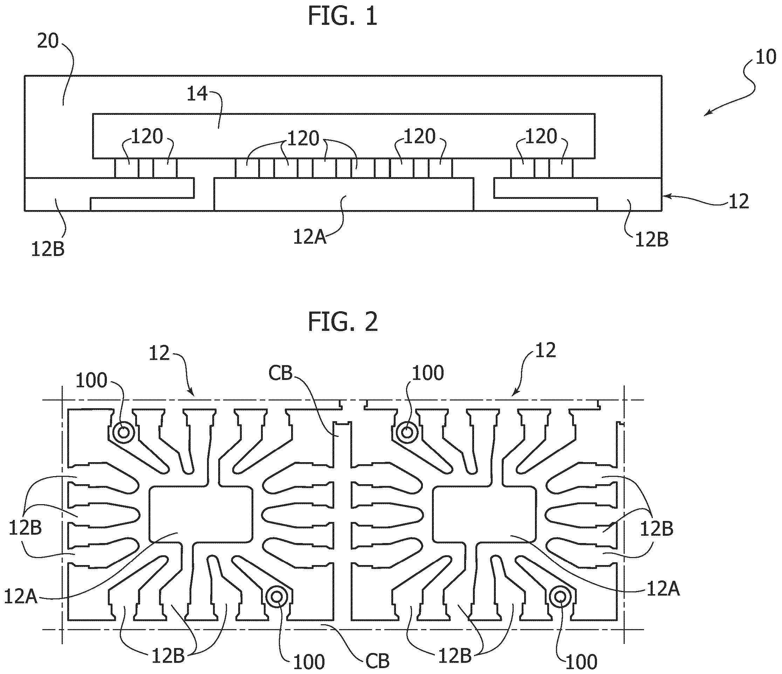

Figure 1 is a cross-sectional view of an (integrated circuit, IC) semiconductor device 10 of the type conventionally referred to as Flip Chip Quad Flat No Leads (FC-QFN). FC-QFN type semiconductor devices 10 as the one illustrated in Figure 1 may be suitable for DC-DC converters or microcontrollers, for instance.

The device 10 exemplified in Figure 1 comprises an electrically conductive substrate or leadframe 12 comprising a die pad 12A having an array of electrically conductive leads 12B arranged peripherally of the die pad 12A.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

In certain cases, a leadframe can be of the pre-molded type, that is a type of leadframe comprising a sculptured metal (copper, for instance) structure formed by etching a metal sheet and comprising empty spaces that are filled by a resin "pre-molded" on the sculptured metal structure.

In flip-chip devices such as the FC-QFN device 10 exemplified in Figure 1, the (IC) semiconductor die 14 may be mounted on the substrate 12 (a leadframe, for instance) via electrically conductive pillars or bumps 120 provided on a surface of the semiconductor die 14.

The electrically conductive pillars 120 may be formed by providing electrically conductive material (a metal such as copper, for instance) via a deposition process such as plating, for instance, or any technique known to those skilled in the art.

Subsequently to providing electrically conductive pillars 120, the semiconductor die 14 is mounted on a substrate 12 (a leadframe, for instance) by contacting the terminal portion of the pillars 120 provided on the surface of the semiconductor die 14 with the substrate 12.

As illustrated in Figure 1, the plurality of pillars 120 may contact the leads 12B and the die pad 12A of the substrate 12 in order to provide the desired electrical coupling between the semiconductor die 14 and the die pad 12A (providing the ground to the device 10, for instance) and/or the leads 12B (providing contacts for input/output, I/O, signals, for instance).

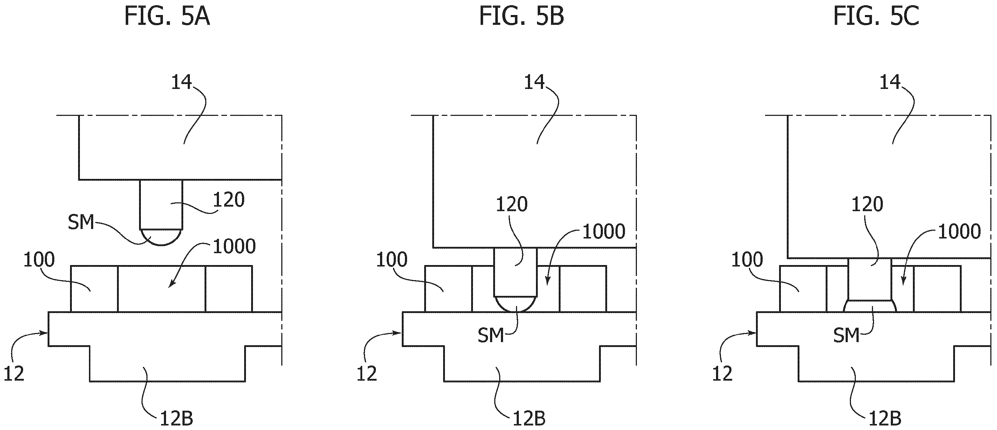

Solder material (tin, for instance) may be provided at the end portion of the pillars 120 to facilitate forming the electrical coupling between the pillars 120 and the substrate/leadframe 12. The solder material (not visible in Figure 1 for simplicity) is illustrated in the sequence of Figures 5A to 5C and referred therein with the reference SM.

As known to those skilled in the art, a reflow step may be performed in order to form the electrical coupling between the pillars 120 and the substrate 12 (the die pad 12A or the leads) via the solder material provided at the terminal portions of the pillars 120 contacting the substrate 12.

Mounting a semiconductor die 14 on a leadframe 12 (or, more generally, a substrate) as illustrated in Figure 1 and described in the foregoing is conventionally referred to as flip-chip mounting.

The device 10 illustrated in Figure 1 is provided with an electrically insulating encapsulation 20 that provides a protective package to the device 10. The encapsulation 20 may be formed via molding of an electrically insulating molding compound (such as an epoxy resin, for instance) on the substrate 12 having the semiconductor die 14 mounted thereon.

A semiconductor device 10 as illustrated in Figure 1 may be configured for being mounted on a supporting substrate such as a printed circuit board, PCB, for instance, possibly via solder material (such as a solder paste, for instance) provided on the bottom/back surface of the device 10.

A device 10 as described in the foregoing is conventional in the art which makes it unnecessary to provide a more detailed description herein.

As mentioned, conventional processing involves arranging a semiconductor die 14 provided with electrically conductive pillars 120 on a substrate, a processing step oftentimes referred to as pick-and-place.

Pick-and-place operations may represent a relatively delicate processing step in so far as misalignment of the semiconductor die 14 on the substrate 12 may cause failure (and/or rejection) of the device.

Misalignment may cause, for instance, an electrically conductive pillar 120 not to contact a desired lead 12B of the substrate 12 thus resulting in an inadequate electrical coupling between the semiconductor die 14 and the substrate 12.

Moreover, even when adequately arranged on the substrate, the semiconductor die 14 may undesirably move from its location during processing; for example, reflow of the solder material provided at the tip of the electrically conductive pillars 120 has been observed to cause the semiconductor die 14 to rotate and move with respect to the substrate 12.

According to a conventional approach, rotation (and, more generally, movement) of the semiconductor die 14 during reflow may be countered via silver spots provided on the substrate 12 at locations configured to contact with the electrically conductive pillars 120. However, such a conventional approach does not provide an adequate solution to the issues described in the foregoing.

Solutions as described herein involve providing alignment formations on a substrate in order to facilitate mounting a semiconductor die thereon.

In solutions as described herein, the alignment formations may comprise ring-shaped enclosures provided on a surface of the substrate and configured to have an electrically conductive pillar inserted therein in order to counter undesired movement of the semiconductor die 14 during handling/processing.

In solutions as described herein, the alignment formations may be provided on the substrate via additive manufacturing techniques such as jetting or laser induced forward transfer, LIFT, for instance.

In solutions as described herein, the alignment formations provided on the substrate provide reference points for the pick-and-place operations thus facilitating mounting operations.

Solutions as described herein may advantageously be applied to flip-chip package devices for DC-DC converters or microcontrollers, for instance.

Figure 2 is illustrative of (two) substrates 12 such as leadframes, provided with alignment formations 100 according to embodiments of the present description. The substrates 12 illustrated in Figure 2 may be a portion of a common substrate comprising a plurality of individual substrates 12.

In fact, in current manufacturing processes of (integrated circuit) semiconductor devices plural devices/leadframes are processed concurrently. To that effect, a plurality of (individual) leadframes 12 are arranged in a leadframe strip (or reel) and held together via sacrificial connecting bars CB running at the periphery of the individual leadframes 12.

The sacrificial connecting bars CB may be removed in a final singulation step (by sawing, for instance) thus obtaining a plurality of (finished) individual devices.

For simplicity and ease of explanation, the following description will refer to manufacturing a single device.

As illustrated in Figure 2, two (or more) alignment formations 100 may be provided at the mounting surface of an individual substrate 12, that is, the surface of the substrate 12 configured to have a semiconductor die 14 mounted thereon.

The alignment formations 100 comprise bushings delimiting an inner region sized and dimensioned to have one electrically conductive pillar 120 inserted therein.

The alignment bushings 100 may comprise raised formations, possibly of an electrically insulating material such as non-conductive adhesive (NCA), resin paste, liquid resin, organic substrate material, resist materials, for instance.

As illustrated in Figure 2, the alignment bushings 100 may be ring-shaped. According to other embodiments the alignment formations 100 may comprise bushings having a different shape such as elliptical, square or hexagonal shape, for instance.

In the example illustrated in Figure 2 two alignment formations 100 are provided on corresponding leads 12B at opposing sides of the die pad 12A.

However, the number and/or the location of the alignment formations or bushings 100 illustrated in Figure 2 are merely exemplary of a possible, advantageous configuration for a substrate 12 as exemplified in the figure; in general, more than two alignment formations or bushings 100 may be provided at locations of the substrate 12 that may be different from what is illustrated in Figure 2.

The alignment formations 100 may be provided via an additive manufacturing technique such as jetting, for instance or, advantageously, via laser induced forward transfer, LIFT.

The acronym LIFT denotes a deposition process where material from a donor tape or sheet is transferred to an acceptor substrate (here, the substrate 12) facilitated by laser pulses.

General information on the LIFT process can be found, for instance, in P. Serra, et al.: "Laser-Induced Forward Transfer: Fundamentals and Applications", in Advanced Materials Technologies/Volume 4, Issue 1.

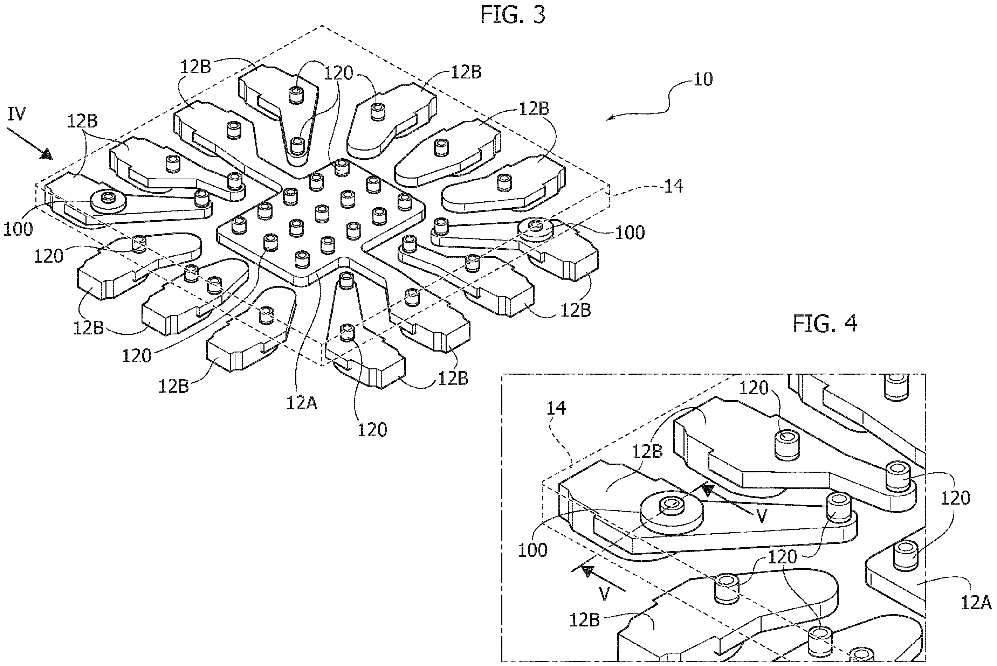

Figures 3 and 4 are perspective views (wherein Figure 4 is an enlarged view of the portion of Figure 3 indicated by the arrow IV) illustrative of a (integrated circuit) semiconductor die 14 mounted on a substrate 12 having alignment formations such as bushings 100 provided on a surface thereof.

As illustrated, the semiconductor die 14 may be provided with a plurality of electrically conductive pillars 120 (or bumps) configured to be in electrical contact (possibly via solder material) the substrate 12 to provide the desired electrical coupling between the substrate 12 and the semiconductor die 14.

In the embodiment illustrated in Figures 3 and 4 two alignment bushings 100 are provided on respective leads 12B of the substrate 12.

The alignment bushings 100 facilitate alignment of the semiconductor die 14 on the substrate during the pick-and-place operation.

As illustrated, the location of the alignment bushings 100 may be chosen to match the position of two electrically conductive pillars 120 so that the pillars 120 may be inserted in the alignment bushings 100 when the semiconductor die 14 is mounted on the substrate 12.

According to embodiments of the present description, additional dummy pillars 120, that is, pillars 120 that are not used for providing input/output signals to the semiconductor die 14, may be formed at the surface of the semiconductor die 14 with the purpose of being inserted into the alignment bushings 100, thus facilitating alignment of the semiconductor die 14 on the substrate 12.

Figures 5A to 5C are cross-sectional views along line V-V of Figure 4 illustrative of a sequence of steps in mounting a semiconductor die 14 on a substrate 12 according to embodiments of the present description.

Figure 5A is illustrative of a semiconductor die 14 aligned with a substrate 12; as illustrated the position of the pillar 120 on the semiconductor die 14 matches the position of the alignment bushing 100 on the substrate 12.

As illustrated, solder material SM (tin, for instance) may be provided at the tip of the pillar 120 protruding from the semiconductor die 14. Subsequently to reflow, solder material SM facilitates forming an electrical coupling between the substrate 12 and the pillar 120.

Figure 5B is illustrative of the mounting of the semiconductor die 14 on the substrate 12 by contacting the pillar with the substrate 12 (via solder material SM) .

As illustrated, the alignment bushings 100 provide a sort of enclosure around the electrically conductive pillar 120.

Said otherwise, the electrically conductive pillars 120 are inserted into the alignment bushings 100, into the inner region 1000 of the bushing 100. To that effect, size and dimensions of the bushing 100 may be chosen in such a way to match the width of the electrically conductive pillars 120.

Advantageously, alignment bushings 100 may be formed with an inner region 1000 wider than the electrically conductive pillars 120 in order to account for possible (relatively small) errors during the pick-and-place operation.

For example, in current flip-chip semiconductor devices such as microcontrollers or DC-DC converters, for instance, solutions as described herein contemplating an inner region 1000 of the bushings 100 that is 60 to 80 microns wide can adequately counter the movement of the semiconductor die 14 during processing (reflow, for instance) and provide for adequate tolerance to be implemented with conventional pick-and-place tool.

These values are described herein only by way of example and shall not be construed in a limiting sense.

Figure 5C is illustrative of a reflow step performed on the semiconductor die 14 mounted on the substrate 12. A reflow step facilitates forming the desired electrical coupling between the semiconductor die 14 and the substrate 12 via solder material SM provided at the tip of the electrically conductive pillars 120.

The electrically conductive pillars 120 inserted into the alignment bushings 100 counter undesired movement of the semiconductor die 14 during the reflow step. Two alignment bushings 100 have been observed to adequately counter undesired movement (rotation, for instance) of the semiconductor die 14 with respect to the substrate 12 during reflow.

In some embodiments, more than two alignment bushings 100 may be provided at the surface of a substrate 12.

In summary, solutions as described herein involve arranging a semiconductor die 14 at a mounting surface of a substrate 12 via electrically conductive pillars 120 protruding from the semiconductor die 14, with the distal ends of the electrically conductive pillars 120 in electrical contact with the mounting surface of the substrate 12 (possibly with solder material SM provided therebetween).

The substrate 12 has at the mounting surface two or more alignment bushings 100 configured to have inserted therein respective electrically conductive pillars 120 protruding from the semiconductor die 14.

The semiconductor die 14 is arranged at the mounting surface of the substrate 12 inserting selected ones of the electrically conductive pillars 120 protruding from the semiconductor die 14 into the (at least two) alignment bushings 100 at the mounting surface of the substrate 12.

In some embodiments the substrate 12 may comprises an electrically conductive die pad 12A and an array of electrically conductive leads 12B arranged peripherally of the electrically conductive die pad 12A. In this case, two alignment bushings 100 may be arranged at two leads 12B in the array of electrically conductive leads 12B, preferably on opposing sides of the die pad 12A.

Without prejudice to the underlying principles, the details and the embodiments may vary, even significantly, with respect to what has been described by way of example only without departing from the scope of the embodiments.

The extent of protection is determined by the annexed claims.

## Claims

1. A method, comprising:
arranging a semiconductor die (14) at a mounting surface of a substrate (12) via electrically conductive pillars (120) protruding from the semiconductor die (14) with distal ends of the electrically conductive pillars (120) in electrical contact (SM) with the mounting surface of the substrate (12), wherein the substrate (12) has at said mounting surface at least two alignment bushings (100) configured to have inserted therein respective electrically conductive pillars (120) protruding from the semiconductor die (14),
wherein arranging the semiconductor die (14) at the mounting surface of the substrate (12) comprises inserting selected ones of the electrically conductive pillars (120) protruding from the semiconductor die (14) into said at least two alignment bushings (100) at the mounting surface of the substrate (12), wherein the pillars (120) inserted into the alignment bushings (100) counter movement of the semiconductor die (14) with respect to the substrate (12), wherein the alignment bushings (100) at the mounting surface of the substrate (12) comprise electrically insulating bushings (100).

2. The method of claim 1, wherein the alignment bushings (100) comprise ring-shaped formations at the mounting surface of the substrate (12).

3. The method of claim 1 or claim 2, wherein the alignment bushings (100) comprise raised formations on the mounting surface of the substrate (12).

4. The method of any of the previous claims, wherein the substrate (12) comprises an electrically conductive die pad (12A) and an array of electrically conductive leads (12B) arranged peripherally of the electrically conductive die pad (12A), and wherein the at least two alignment bushings (100) configured to have respective electrically conductive pillars (120) inserted therein are arranged at two leads (12B) in the array of electrically conductive leads (12B), preferably on opposing sides of the die pad (12A).

5. The method of any of the previous claims, comprising forming said alignment bushings (100) at the mounting surface of the substrate (12) via jetting or laser induced forward transfer, LIFT, technique.

6. The method of any of the previous claims, comprising providing solder material (SM) between the distal ends of the conductive pillars (120) inserted into the alignment bushings (100) and the mounting surface of the substrate (12) to provide electrical contact therewith.

7. A substrate (12) configured to have a semiconductor die (14) arranged at a mounting surface of the substrate (12) via electrically conductive pillars (120) protruding from the semiconductor die (14) with distal ends of the electrically conductive pillars (120) in electrical contact with the mounting surface of the substrate (12), wherein the substrate (12) has at said mounting surface at least two alignment bushings (100) configured to have respective electrically conductive pillars (120) of the semiconductor die (14) inserted therein to counter movement of the semiconductor die (14) with respect to the substrate (12), wherein the alignment bushings (100) at the mounting surface of the substrate (12) comprise electrically insulating bushings (100).

8. The substrate (12) of claim 7, wherein the alignment bushings (100) comprise:
ring-shaped formations at the mounting surface of the substrate (12), and/or
raised formations on the mounting surface of the substrate (12).

9. The substrate (12) of claim 7 or claim 8, wherein the substrate (12) comprises an electrically conductive die pad (12A) and an array of electrically conductive leads (12B) arranged peripherally of the electrically conductive die pad (12A), and wherein the at least two alignment bushings (100) are arranged at two leads (12B) in the array of electrically conductive leads (12B), preferably on opposing sides of the die pad (12A).

10. A device (10), comprising:
a substrate (12) according to any of claims 7 to 9; and
a semiconductor die (14) arranged at a mounting surface of the substrate (12) via electrically conductive pillars (120) protruding from the semiconductor die (14) with distal ends of the electrically conductive pillars (120) in electrical contact with the mounting surface of the substrate (12), wherein selected ones of the electrically conductive pillars (120) at the surface of the semiconductor die (14) are inserted into said at least two alignment bushings (100) at the mounting surface of the substrate (12) .

11. The device of claim 10, comprising solder material (SM) between the distal ends of the conductive pillars (120) inserted into the alignment bushings (100) and the mounting surface of the substrate (12) to provide electrical contact therewith.
